# EUROPEAN PATENT SPECIFICATION

(11) **EP 2 320 570 B1**
(45) Date of publication and mention of the grant of the patent: **08.02.2012**
(21) Application number: 09175438.2
(22) Date of filing: 09.11.2009
(51) Int. Cl.: H03L 7/093, H03L 7/107

(54) **Hysteresis nonlinear state machine with overlapping thresholds for automatic frequency control**
Nichtlineare Hysteresezustandsmaschine mit überlappenden Grenzwerten zur automatischen Frequenzsteuerung
Machine non linéaire à états avec hysteresis comportant des seuils en chevauchement pour le contrôle automatique de fréquence

(43) Date of publication of application: 11.05.2011
(73) Proprietor: RESEARCH IN MOTION LIMITED, Waterloo, Ontario N2L 3W8 (CA)
(72) Inventor: Canpolat, Onur, Waterloo Ontario N2L 3W8 (CA); Onochie, Francis Chukwuemeka, Waterloo Ontario N2L 3W8 (CA)
(74) Representative: Patel, Binesh

(56) References cited:
- WO-A1-03/023967
- WO-A2-2007/057911
- US-A1- 2007 268 828

## Description

### TECHNICAL FIELD

The present disclosure relates to frequency tracking in wireless mobile devices and in particular to improving the performance of tracking in automatic frequency control of voltage controlled oscillator in the frequency tracking process.

### BACKGROUND

In wireless mobile devices, conventional non-linear control system for automatic frequency control (AFC) of a voltage-controlled oscillator (VCO) is required for synchronization with a received radio frequency channel. This requires frequent switching or correction depending on the operating state of the wireless device. Variability in the RF channel quality during different phases such as initialization, cell hand-offs or deep channel fades can require frequent switching back and forth between control states which can lead to instability and phase jitter in the tracking process. In VCO control system the adjustment of the filter coefficients in the adaption process has to ensure optimum tracking performance for both transient and steady state response as well as stability. The inability to provide the appropriate filter coefficients based upon the current operating state in the wireless devices results in processing delays and inefficient resource utilization.

WO 03/023967 A1 relates to a phase-locked loop that is dynamically and automatically altered in response to changes in the jitter of the input.

WO 2007/057911 A2 relates to a receiver which includes an input circuit, which is coupled to at least one antenna so as to receive, process and digitize first and second signals, thus generating first and second streams of input samples.

Accordingly, methods and apparatus that enable improved automatic frequency control remains highly desirable.

### SUMMARY

In accordance with the present disclosure there is provided a method of non-linear frequency control tracking of a control loop of a voltage controlled oscillator (VCO) in a wireless mobile device receiver, as recited in claim 1.

In accordance with another aspect of the present disclosure there is provided an apparatus for providing hysteresis non-linear frequency tracking of a control loop in a frequency generator of a wireless mobile device having a voltage controlled oscillator (VCO) and an adaptive loop filter, as recited in claim 7.

### BRIEF DESCRIPTION OF THE DRAWINGS

Further features and advantages of the present disclosure will become apparent from the following detailed description, taken in combination with the appended drawings, in which:
FIG. 1 shows a block diagram representation of wireless mobile device;
FIG. 2 shows a representation of a hysteresis non-linear frequency control loop;
FIG. 3 shows a representation of overlapping thresholds used at state transitions in a hysteresis two-state machine:
FIG. 4 shows a hysteresis three-operating state diagram for non-linear frequency tracking;
FIG. 5 shows hysteresis four-operating state diagram for non-linear frequency tracking; and
FIG. 6 shows a method for hysteresis non-linear frequency tracking.

It will be noted that throughout the appended drawings, like features are identified by like reference numerals.

### DETAILED DESCRIPTION

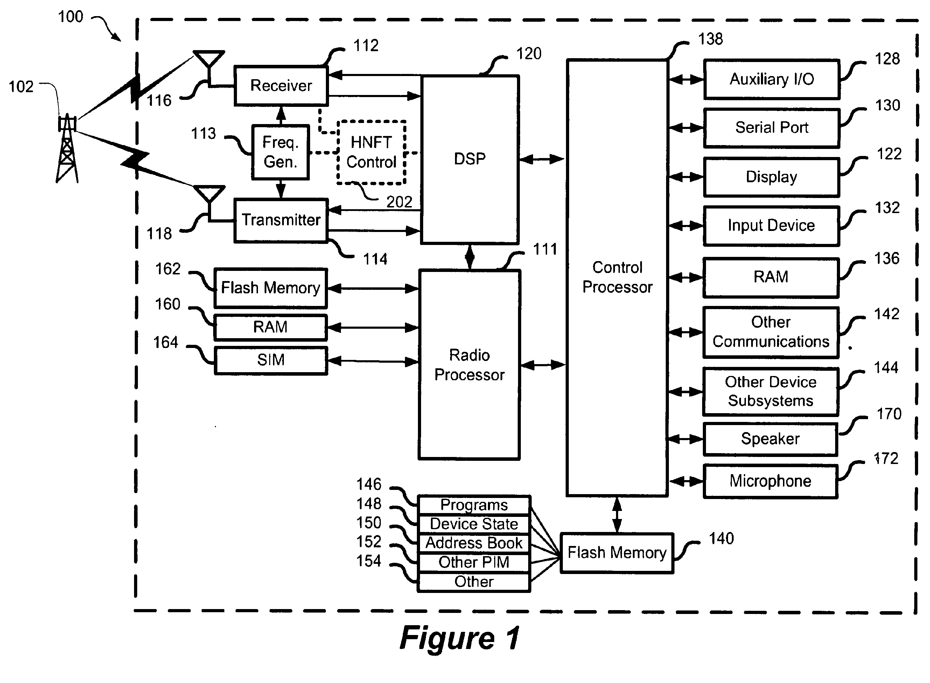

Embodiments arc described below, by way of example only, with reference to Figs. 1-6.

The present disclosure provide a system and apparatus for providing non-linear frequency tracking of a frequency generator in a wireless device using overlapping thresholds in state transitions to create hysteresis between operating states. The hysteresis state machine controls the adaptive loop filter coefficients during the frequency tracking process. The ability to change the adaptive loop filter coefficients results in fast transient response for reaching the steady state and narrows the loop bandwidth to minimize the output phase jitter due to noisy frequency estimates.

Figure 1 is a block diagram of a wireless mobile device **100** incorporating a communication subsystem having both a receiver **112** and a transmitter **114,** as well as associated components such as one or more embedded or internal antenna elements **116** and **118,** frequency generator **113** which also includes a control loop for tuning a voltage controlled oscillator (VCO), and a processing module such as a digital signal processor (DSP) **120.** The particular design of the communication subsystem will be dependent upon the communication network in which the device is intended to operate in a wireless network such as GSM, CDMA, HSPA, or 3GPP LTE network.

The wireless mobile device **100** performs synchronization, registration or activation procedures by sending and receiving communication signals over the network **102.** Signals received by antenna **116** through communication network **102** are input to receiver **112,** which may perform such common receiver functions as signal amplification, frequency down conversion, filtering, channel selection and the like, and in the example system shown in Figure 1, analog to digital (A/D) conversion. A/D conversion of a received signal allows more complex communication functions such as demodulation, decoding and synchronization to be performed in the DSP **120.**

In a similar manner, signals to be transmitted are processed, including modulation and encoding for example, by DSP **120** and input to transmitter **114** for digital to analog conversion, frequency up conversion, filtering, amplification and transmission over the communication network **102** via antenna **118.** DSP **120** not only processes communication signals, but also provides for VCO AFC control, as well as receiver and transmitter control.

Wireless device **100** preferably includes a radio processor **111** and a control processor **138** which together control the overall operation of the device. DSP **120** may be located within radio processor **111.** Communication functions are performed through radio processor **111.** If the DSP **120** is separate from radio processor **111,** functions of the VCO AFC control may be shared in whole or in part between the processors.

Radio processor **111** interacts with receiver **112** and transmitter **114,** and further with the subscriber identity module **164.** The radio processor **111** may also interact with flash memory **162,** random access memory (RAM) **160,** which may be external components or integrated within the radio processor **111.**

Control processor **138** interacts with further device subsystems such as the display **122,** flash memory **140,** random access memory (RAM) **136,** auxiliary input/output (I/O) subsystems **128,** serial port **130,** keyboard **132** or a touch interface, other communications **142,** other device subsystems generally designated as **144** and transmits and receives audio from a speaker **170** and a microphone **172.**

Some of the subsystems shown in Figure 1 perform communication-related functions, whereas other subsystems may provide "resident" or on-device functions. Notably, some subsystems, such as keyboard **132** and display **122,** for example, may be used for both communication-related functions, such as entering a text message for transmission over a communication network, and device-resident functions such as a calculator or task list.

Software used by radio processor **111** and microprocessor **138** is preferably stored in a persistent store such as flash memory **140** and **162,** which may instead be a read-only memory (ROM) or similar storage element (not shown). Those skilled in the art will appreciate that the operating system, specific device applications, or parts thereof, may be temporarily loaded into a volatile memory such as RAM **136** and RAM **160.**

As shown, flash memory **140** can be segregated into different areas for computer programs **146,** device state **148,** address book **150,** other personal information management (PIM) **152** and other functionality generally designated as **154.** These different storage types indicate that each program can allocate a portion of flash memory **140** for their own data storage requirements. Control processor **138,** in addition to its operating system functions, preferably enables execution of software applications on the mobile station.

For voice communications, overall operation of wireless mobile device **100** is similar, except that received signals would preferably be output to the speaker **170** or headset and signals for transmission would be generated by the microphone **172.** Alternative voice or audio I/O subsystems, such as a voice message recording subsystem, may also be implemented on mobile network **102.**

Serial port **130** in Figure 1 would normally be implemented in a personal digital assistant (PDA)-type wireless mobile device for which synchronization with a user's desktop computer (not shown) may be desirable, but is an optional device component. Such a port **130** would enable a user to set preferences through an external device or software application and would extend the capabilities of wireless mobile device **100** by providing for information or software downloads to wireless mobile device **100** other than through a wireless communication network. The alternate download path may for example be used to load an encryption key onto the device through a direct and thus reliable and trusted connection to thereby enable secure device communication.

Other device subsystems **144,** such as a short-range communications subsystem, is a further optional component which may provide for communication between wireless mobile device **100** and different systems or devices, which need not necessarily be similar devices. For example, the subsystem **144** may include an infrared device and associated circuits and components or a Bluetooth™ communication module to provide for communication with similarly enabled systems and devices.

The mobile device **100** further includes an Hysteresis Non-Linear Frequency Tracking (HNFT) Control **202,** as described further herein, for controlling the frequency generator **113.**

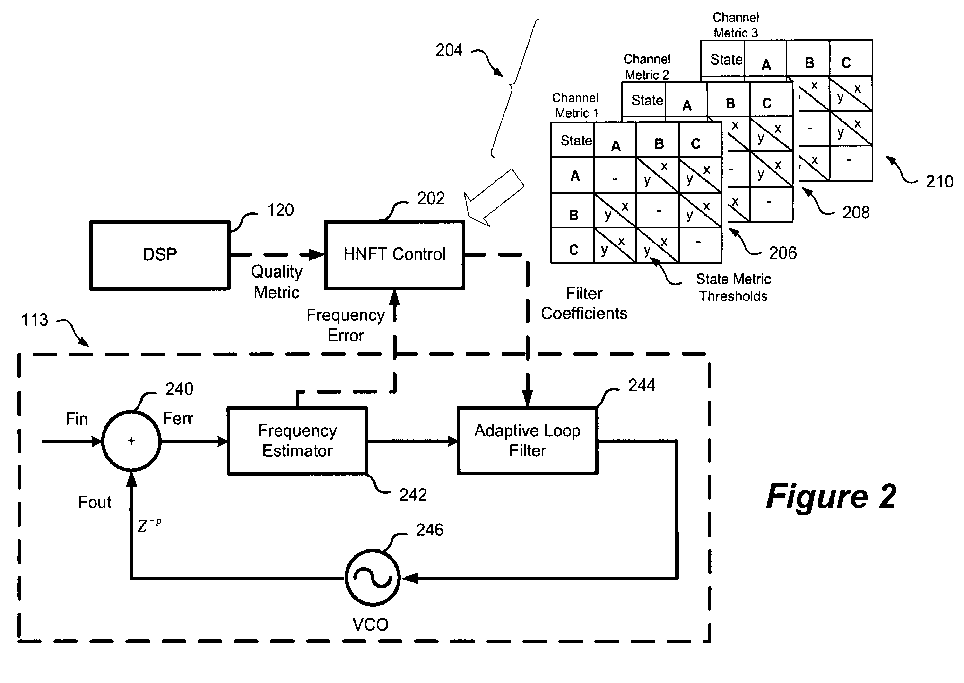

Figure 2 provides an overall control loop model with Hysteresis Nonlinear Frequency Tracking (HNFT) Control as provided in wireless mobile device **100.** The frequency generator **113** generates a signal provided to the receiver **112** and transmitter **114.** The frequency generator **113** compares the output signal of a VCO **246,** having frequency (Fout), with the incoming signal, having frequency (Fin), from the received RF channel at a phase detector **240.** The output of the phase detector **240** is provided to a frequency estimator **242** to estimate the frequency difference between the two signals. The output of the frequency estimator **242** is noisy and requires filtering by an adaptive loop filter **244.** However the bandwidth of the filter **244** can be adjusted by providing optimum coefficients based upon the order and type of the filter selected to improve system performance.

The HNFT control **202** module provides the ability to determine the appropriate coefficients for the adaptive loop filter based upon channel and state metrics. The control loop can then change from different states of operation based upon the current operating environment of the wireless device to provide more accurate VCO **246** control and limit possible instability and phase jitter that can result from coefficients that are inappropriate for current channel characteristics. The HNFT control **202** receives channel quality indicators from the DSP **120** such as but not limited to signal-to-noise ratio of the received channel, bit-error rate of the received channel, a received signal strength measurements, and carrier-to-interference-plus-noise ratios (C/I+N) to determine a channel metric. The channel metric can be determined by generating a weighted function of one or more of the channel quality indicators, where each of the channel quality indicators is assigned a different weight to determining the channel metric function. The selection of the channel quality indicators may be based upon possible output data available from the DSP terms of channel quality in processing the received signal. In addition the decision of which parameter to use may be related to the received signal type or RF characteristics associated with the operation of the wireless device on the network.

A state metric is also determined based upon the received frequency error but may also include a weighted function of the current channel metric and/or weightings associated with one or more previous states that the HNFT has transitioned through. The previous state values may also be weighted based upon a time value in relation to how long ago the previous state transition occurred. Knowledge of the previous operating state may be useful when determining the optimal operating state, and so the filter coefficients, during operational transitions such as initialization, hand-offs or fades where the signal characteristics can vary considerably and benefit from further defining which state may be desirable or undesirable if as the transition occurs.

Each operating state is associated with filter coefficients which are provided to the adaptive loop filter **244** when transitioning to the determined state by the HNFT control module **202.** The HNFT control module **202** utilizes the determined channel metric to select an associated channel metric table **204** which may comprise multiple sub-tables **206, 208, 210** each associated with a channel metric values or a range of channel metric values. Each table provides state metric threshold values defining transitions between operating states. The threshold values are used for determining when to transitions from one operating state to the next state in relation to the determined state metric for a given channel metric or a range of channel metrics. Each of the operating states have defined filter coefficients associated with the operating state to change the filtering properties of the adaptive loop filter **244.** The number of coefficients is based upon the order and operation of the adaptive loop filter. The table defines a different threshold value for transitioning from a first operating state to a second operating state and a transitioning from the second operating state to the first operating state.

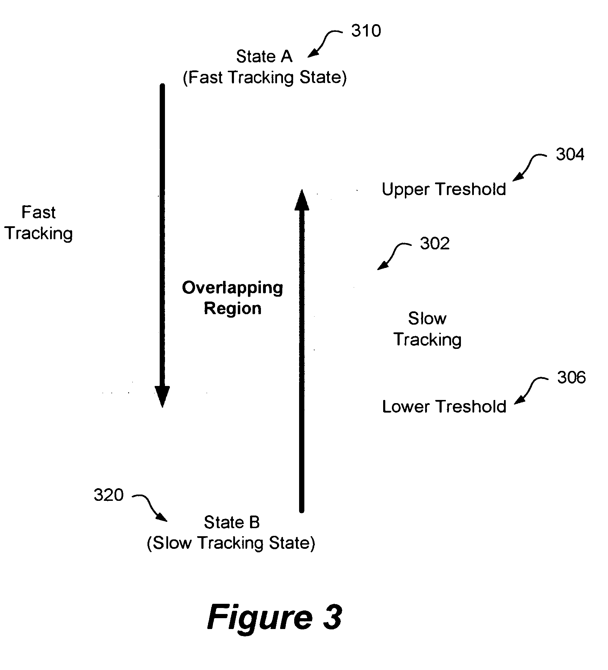

Figure 3 is an example of an operating state transition from fast to slow and slow to fast states in the state machine. In the simplest implementation two operating state transitions, operating state A **310** and operating state B **320** would be provided. The operating states may represent a fast tracking state and a slow tracking state respectively and each have different filter coefficient requirements associated with the operating state. When the control loop is in the fast tracking state A **310,** a lower threshold is determined for when to transition to the slow tracking state B **320.** The threshold is based upon the determined channel and state metrics. This threshold is not the same as when the control loop is in slow tracking state B **320** and the channel and state metric varies sufficiently to require a state change to the fast tracking state A **310.** The overlapping between states **302** provides and upper threshold **304** and lower threshold **306** where hysteresis occurs in the state transitions to ensure that filter coefficients are not loaded prematurely to reduce instability and phase jitter. As shown in the figure there is an overlapping region where both states can operate separately to reduce phase jittering and switching operating states back and forth.

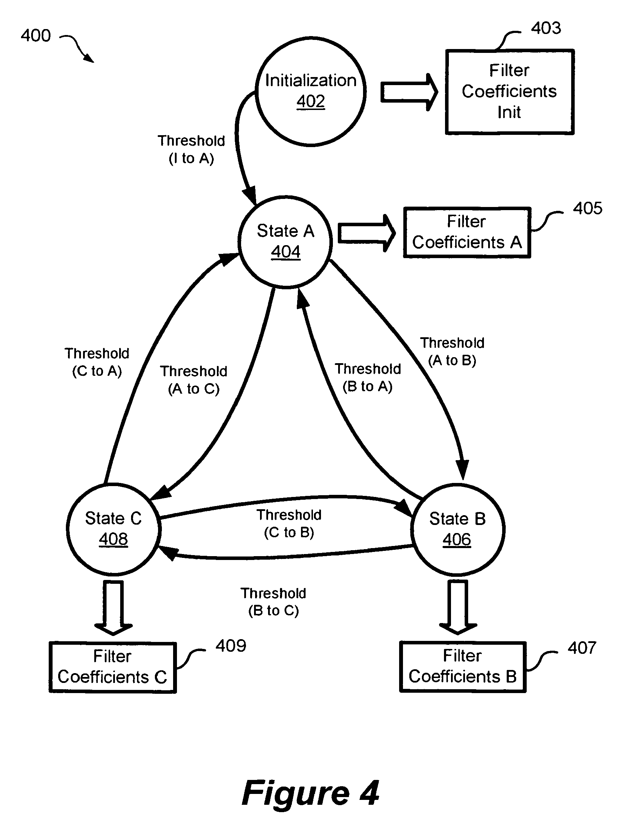

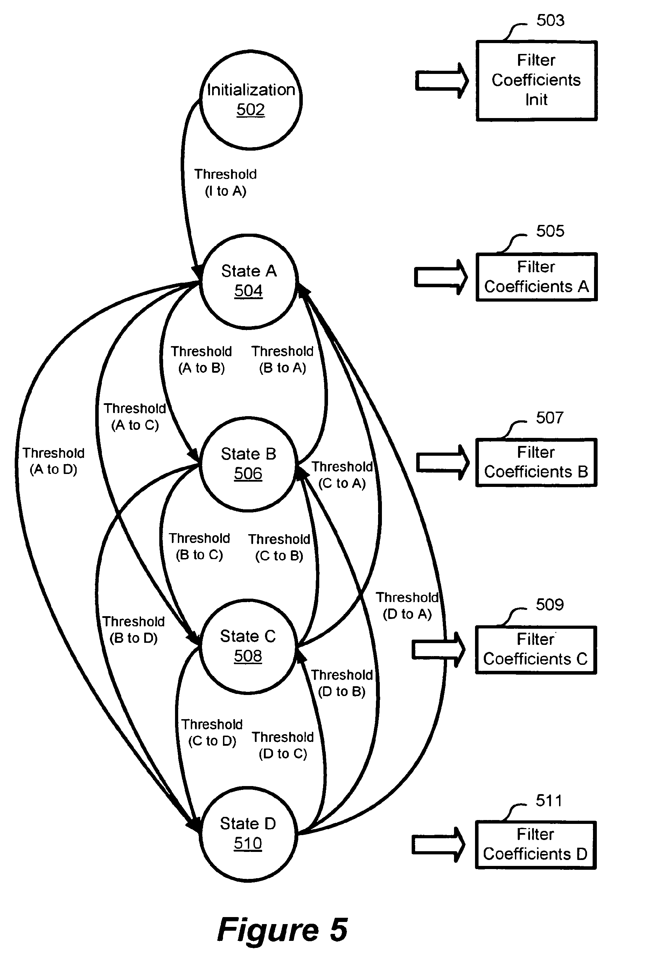

Figure 4 & 5 show a three and four operating state diagrams respectively including an initialization state in accordance with the present disclosure. The states are not limited to the ones provided and can be expanded to include additional states based upon the filter requirements such as the order of the filter and overall performance requirements.

Figure 4 shows a hysteresis three operating state diagrams for non-linear frequency tracking **400.** Initialization state **402** provides filter coefficients for an initialization phase **403** to optimize single acquisition. To move from the initialization state a threshold (I to A) is defined, there is no hysteresis back to the initialization state as it is assumed that the initialization state will only occur at start-up and will not be transitioned back to during normal operation. It should be understood that an initialization operating state **402** may not be required by the HNFT control module **202** based upon how the operating states are defined in relation to the channel and state metric. For each of the operating states, associated thresholds are defined in the table **204** for each defined channel metric or channel metric ranges.

Operating state A **404** having filter coefficients A **405** would have two state metric threshold states associated with it for a given channel metric:

moving to state B threshold is (A to B)

moving to state C threshold is (A to C)

Operating state B **406** having filter coefficients B **407** would have two state metric threshold states associated with it for a given channel metric:

moving to state A threshold is (B to A)

moving to state C threshold is (B to C)

Operating state C **408** having filter coefficients C **409** would have two state metric threshold states associated with it for a given channel metric:

moving to state A threshold is (C to A)

moving to state B threshold is (C to B)

In a three-state machine, the HNFT control provides state metric thresholds to transition to and from each operating state based upon the associated determined channel metric.

Figure 5 shows a hysteresis four operating state diagram for non-linear frequency tracking **500.** Initialization state **502** provides filter coefficients for an initialization phase **503** to optimize single acquisition. To move from the initialization state a threshold (I to A) is defined, there is no hysteresis back to the initialization state as it is assumed that the initialization state will only occur at start-up and will not be transitioned back to during normal operation. It should be understood that an initialization operating state **502** may not be required by the HNFT control module **202** based upon how the operating states are defined in relation to the channel and state metric . For each of the operating states associated state metric thresholds are defined in the table **204.**

Operating state A **504** having filter coefficients A **505** would have three state metric threshold states associated with it for a given channel metric:

moving to state B threshold is (A to B)

moving to state C threshold is (A to C)

moving to state D threshold is (A to D)

Operating state B **506** having filter coefficients B **507** would have three state metric threshold states associated with it for a given channel metric:

moving to state A threshold is (B to A)

moving to state C threshold is (B to C)

moving to state D threshold is (B to D)

Operating state C **508** having filter coefficients C **509** would have three state metric threshold states associated with it for a given channel metric:

moving to state A threshold is (C to A)

moving to state B threshold is (C to B)

moving to state D threshold is (C to D)

Operating state D **510** having filter coefficients C **511** would have three state metric threshold states associated with it for a given channel metric:

moving to state A threshold is (D to A)

moving to state B threshold is (D to B)

moving to state C threshold is (D to C)

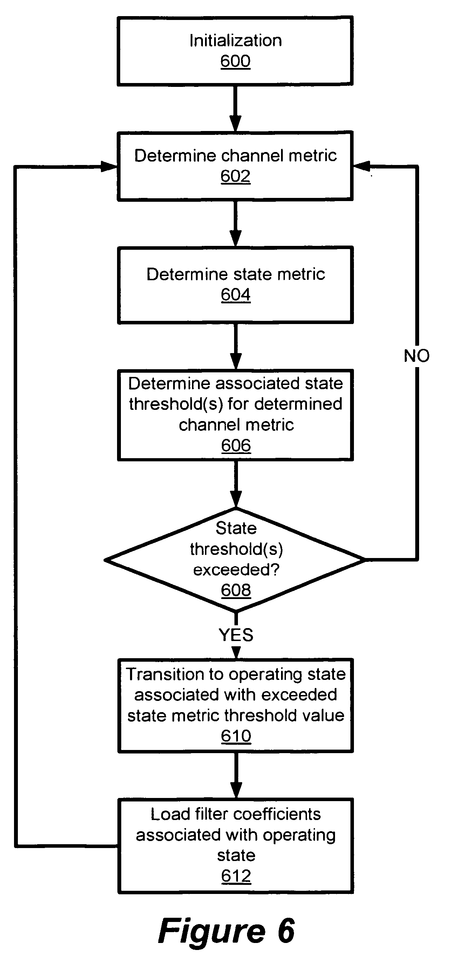

Figure 6 is a method of non-linear frequency control of a control loop of a voltage controlled oscillator (VCO) provided by a frequency generator in a wireless mobile device. The method may be implemented by a processor resident within the wireless mobile device such as the DSP **120,** by a dedicated processor, or utilizing processing power of radio processor **111** or control processor **138.** If the mobile wireless device is in the initialization phase **600,** it loads initialization coefficients in to the adaptive loop filter as a default filter configuration. When the defined threshold for the channel metric is exceeded during the initialization state, the HNFT control **202** transitions to the first operating state. A channel metric associated with a received radio frequency channel is then determined **602.** The channel metric generated as a weighted function of one or more channel quality indicators provided by the DSP **120.** A state metric associated with the control loop is determined **604** as a weighted function of one or more parameters. The state metric may include a weighting of the frequency error of the VCO in relation to the received radio frequency channel, a weighted function of the determined channel metric, one or more previous state metrics associated with a previous operating state weighted by time relative to the current operating state. The time parameter provides a weight component to the previous operating state metric wherein the time parameter decreases the weighting of the previous operating state metric based on received radio frequency channel characteristics.

One or more state metric threshold values is then determined **606** based on the determined channel metric. The one or more state metric threshold values can be selected based upon the associated operating states transitions. The state metric threshold values can be provided in a table **204** defining operating state transitions for each of the states in the control loop. The state metric threshold defines the state metric value that must be exceeded in order to transition to the next operating state based upon the channel metric value. The channel metric table **204** can be stored in memory **162** or **160** or may be resident within the DSP. If the one of the one or more threshold values is exceeded **608,** based on the determined state metric, the control loop transitions to the operating state, YES at **608,** associated with the threshold **610.** For a new operating state, at least one coefficient is loaded **612** to the adaptive loop filter of the control loop. Depending on the order adaptive filter, the number of coefficients provided may vary for each operating state. The state metric threshold values are selected to provide a hysteresis function to transitions between operating states to remove instability and improved transient response. The method continues with the channel metric again being determined at **602.** If thresholds are not exceeded, NO at **608,** the channel metric is again determined at **602** until a transition occurs.

While a particular embodiment of the present method and apparatus for Hysteresis Non-Linear Frequency Tracking has been described herein, it will be appreciated by those skilled in the art that changes and modifications may be made thereto without departing from the disclosure in its broadest aspects and as set forth in the following claims.

## Claims

1. A method of non-linear frequency control tracking of a control loop of a voltage controlled oscillator - hereafter abbreviated VCO- (246) in a wireless mobile device (100) receiver, the method comprising:
determining (602) a channel metric based on one or more channel quality indicators associated with a received radio frequency channel;
determining (604) a state metric associated with the current operating state of the control loop;
determining (606) one or more state metric threshold values associated with the determined channel metric, the one or more state metric threshold values selected from a plurality of state metric threshold values each associated with a transition to a possible operating state of the control loop, from the current operating state, by performing a lookup in a table comprising one or more sub-tables each sub-table associated with a channel metric value or a range of channel metric values, the table defining a plurality of state metric thresholds for each transition to and from said possible operating states;
determining (608) if one of the one or more state metric threshold values has been exceeded based upon the determined state metric, wherein the state metric threshold value is defined for each transition between each of said possible operating states;
transitioning (610) from the current operating state to the operating state associated with the exceeded state metric threshold value; and
providing (612) at least one coefficient to an adaptive loop filter of the control loop, the at least one coefficient associated with the transitioned operating state;
wherein the state metric threshold values associated with the operating states provide overlapping regions between common operating states to provide hysteresis for operating state transitions.

2. The method of claim 1 wherein the channel metric is based upon one or more channel quality indicators determined for the received radio frequency channel.

3. The method of claim 2 wherein the channel metric is a function of one or more channel quality indicators selected from a signal-to-noise ratio of the received channel, bit-error rate of the received channel, a received signal strength measurements, and carrier-to-interference-plus-noise ratios (C/I+N) wherein the, or each, channel quality indicator has a corresponding weighting in determining the channel metric.

4. The method of any one of claims 1 to 3 wherein the state metric comprises a function of a frequency error between the frequency of the received radio frequency channel and an output frequency of the VCO.

5. The method of claim 4, wherein the state metric is further a function of at least one of:
a weighted function of the current channel metric; and
one or more previous operating state metrics weighted by a time parameter, wherein the time parameter decreases the weighting of the previous operating state metric.

6. The method of any one of claims 1 to 5 wherein when determining one or more state metric threshold values is associated with an initialization state, providing default initialization coefficients defined for the adaptive loop filter and wherein only one threshold is defined for the channel metric and wherein the initialization state occurs during mobile wireless device start-up.

7. An apparatus (202) for providing hysteresis non-linear frequency tracking of a control loop in a frequency generator (113) of a wireless mobile device (100) having a voltage controlled oscillator - hereafter abbreviated VCO- (246) and an adaptive loop filter, the apparatus comprising:
a memory (160, 162) ;
a processor (120, 111) for providing coefficients to said adaptive loop filter (244) from a plurality of coefficients, each of the plurality of coefficients associated with an operating state of the frequency generator (113) wherein the operating state is determined by:
determining (602) a channel metric based upon one or more channel quality indicators associated with a received radio frequency channel;
determining (604) a state metric associated with the control loop based on the operating state of the control loop;
determining (606) one or more state metric threshold values associated with the determined channel metric a table stored in the memory, from the one or more state metric threshold values selected from a plurality of state metric threshold values each associated with a transition to a possible operating state of the control loop from the current operating state, by performing a lookup in a table comprising one or more sub-tables each sub-table associated with a channel metric value or a range of channel metric values, the table defining a plurality of state metric thresholds for each transition to and from said possible operating states;
determining (608) if one of the one or more state metric threshold values has been exceeded based upon the determined state metric, wherein the state metric threshold value is defined for each transition between each of said possible operating states; and
transitioning (610) from operating state to the operating state transitioning (610) from the current operating state to the operating state associated with the exceeded state metric threshold value;
wherein the state metric threshold values associated with the operating states provide overlapping regions between common operating states to provide hysteresis for operating state transitions.

8. The apparatus of claim 7 wherein the channel metric is based upon one or more channel quality indicators determined for the received radio frequency channel.

9. The apparatus of claim 8 wherein the channel metric is a function of one or more channel quality indicators selected from a signal-to-noise ratio of the received channel, bit-error rate of the received channel, a received signal strength measurements, and carrier-to-interference-plus-noise ratios (C/I+N) wherein the, or each, channel quality indicator has a corresponding weighting in determining the channel metric.

10. The apparatus of any one of claims 7 to 9 wherein the state metric comprises a function of a frequency error between the frequency of the received radio frequency channel and an output frequency of the VCO.

11. The apparatus of claim 10, wherein the state metric is further a function of at least one of:
a weighted function of the current channel metric; and
one or more previous operating state metrics weighted by a time parameter, wherein the time parameter decreases the weighting of the previous operating state metric.

## Patentansprüche

1. Verfahren einer nicht-linearen Frequenzssteuerungsverfolgung eines Regelkreises eines spannungsgesteuerten Oszillators - im Folgenden als VCO (voltage controlled oscillator) (246) abgekürzt - in einem Empfänger einer drahtlosen mobilen Vorrichtung (100), wobei das Verfahren aufweist:
Bestimmen (602) einer Kanalmetrik basierend auf einem oder mehreren Kanalqualitäts-Indikatoren, die mit einem empfangenen Funkfrequenzkanal assoziiert sind;
Bestimmen (604) einer Zustandsmetrik, die mit dem aktuellen Betriebszustand des Regelkreises assoziiert ist;
Bestimmen (606) eines oder mehrerer Zustandsmetrik-Schwellenwerte, die mit der bestimmten Kanalmetrik assoziiert sind, wobei der eine oder die mehreren Zustandsmetrik-Schwellenwerte, die ausgewählt sind aus einer Vielzahl von Zustandsmetrik-Schwellenwerten, die jeweils mit einem Übergang in einen möglichen Betriebszustand des Regelkreises von dem aktuellen Betriebszustand assoziiert sind, durch Durchführen einer Suche in einer Tabelle, die eine oder mehrere Teiltabellen aufweist, wobei jede Teiltabelle mit einem Kanalmetrikwert oder einem Bereich von Kanalmetrikwerten assoziiert ist, wobei die Tabelle eine Vielzahl von Zustandsmetrikschwellen für jeden Übergang in die und von den möglichen Betriebszuständen definiert;
Bestimmen (608), ob einer des einen oder der mehreren Zustandsmetrik-Schwellenwerte überschritten wurde, basierend auf der bestimmten Zustandsmetrik, wobei der Zustandsmetrik-Schwellenwert für jeden Übergang zwischen jedem der möglichen Betriebszustände definiert ist;
Übergehen (610) von dem aktuellen Betriebszustand in den Betriebszustand, der mit dem überschrittenen Zustandsmetrik-Schwellenwert assoziiert ist; und
Vorsehen (612) zumindest eines Koeffizients für einen adaptiven Schleifenfilter des Regelkreises, wobei der zumindest eine Koeffizient mit dem übergegangenen Betriebszustand assoziiert ist;
wobei die Zustandsmetrik-Schwellenwerte, die mit den Betriebszuständen assoziiert sind, überlappende Bereiche zwischen gemeinsamen Betriebszuständen vorsehen, um eine Hysteresis für Betriebszustandsübergänge vorzusehen.

2. Verfahren gemäß Anspruch 1, wobei die Kanalmetrik auf einem oder mehreren Kanalqualitätsindikatoren basiert, die für den empfangenen Funkfrequenzkanal bestimmt werden.

3. Verfahren gemäß Anspruch 2, wobei die Kanalmetrik eine Funktion eines oder mehrerer Kanalqualitätsindikatoren ist, die ausgewählt sind aus einem Signal-zu-Rauschen-Verhältnis des empfangenen Kanals, einer Bitfehlerrate des empfangenen Kanals, empfangenen Signalstärke-Messungen und Carrier-zu-Interferenz-plus-Rauschen-Verhältnissen (C/1+N - carrier-to-interference-plus-noise), wobei der oder jeder Kanalqualitätsindikator eine entsprechende Gewichtung bei einem Bestimmen der Kanalmetrik hat.

4. Verfahren gemäß einem der Ansprüche 1 bis 3, wobei die Zustandsmetrik eine Funktion eines Frequenzfehlers zwischen der Frequenz des empfangenen Funkfrequenzkanals und einer Ausgabefrequenz des VCOs aufweist.

5. Verfahren gemäß Anspruch 4, wobei die Zustandsmetrik weiter eine Funktion aus zumindest einem ist:
eine gewichtete Funktion der aktuellen Kanalmetrik; und
eine oder mehrere frühere Betriebszustandsmetriken, gewichtet mit einem Zeitparameter, wobei der Zeitparameter die Gewichtung der früheren Betriebszustandsmetrik verringert.

6. Verfahren gemäß einem der Ansprüche 1 bis 5, wobei, wenn Bestimmen eines oder mehrerer Zustandsmetrik-Schwellenwerte, assoziiert mit einem Initialisierungszustand, Vorsehen von Standard-Initialisierungs-Koeffizienten, definiert für den adaptiven Schleifenfilter, und wobei nur eine Schwelle für die Kanalmetrik definiert wird und wobei der Initialisierungszustand während eines Anschalten der mobilen drahtlosen Vorrichtung stattfindet.

7. Vorrichtung (202) zum Vorsehen einer nicht-linearen Hysteresis-Frequenz-Verfolgung eines Regelkreises in einem Frequenzgenerator (113) einer drahtlosen mobilen Vorrichtung (100) mit einem spannungsgesteuerten Oszillator - im Folgenden als VCO (voltage controlled oscillator) (246) abgekürzt - und einem adaptiven Schleifenfilter, wobei die Vorrichtung aufweist:
einen Speicher (160, 162);
einen Prozessor (120, 111) zum Vorsehen von Koeffizienten für den adaptiven Schleifenfilter (244) aus einer Vielzahl von Koeffizienten, wobei jeder der Vielzahl von Koeffizienten mit einem Betriebszustand des Frequenzgenerators (113) assoziiert ist, wobei der Betriebszustand bestimmt wird durch:
Bestimmen (602) einer Kanalmetrik basierend auf einem oder
mehreren Kanalqualitäts-Indikatoren, die mit einem empfangenen Funkfrequenzkanal assoziiert sind;
Bestimmen (604) einer Zustandsmetrik, die mit dem Regelkreis assoziiert ist, basierend auf dem Betriebszustand des Regelkreises;
Bestimmen (606) eines oder mehrerer Zustandsmetrik-Schwellenwerte, die mit der bestimmten Kanalmetrik assoziiert sind in einer Tabelle, die in dem Speicher gespeichert ist, von dem einen oder mehreren Zustandsmetrik-Schwellenwerten, die ausgewählt sind aus einer Vielzahl von Zustandsmetrik-Schwellenwerten, die jeweils mit einem Übergang in einen möglichen Betriebszustand des Regelkreises von dem aktuellen Betriebszustand assoziiert sind,
durch Durchführen einer Suche in einer Tabelle, die eine oder
mehrere Teiltabellen aufweist, wobei jede Teiltabelle mit einem Kanalmetrikwert oder einem Bereich von Kanalmetrikwerten assoziiert ist, wobei die Tabelle eine Vielzahl von Zustandsmetrikschwellen für jeden Übergang in die und von den möglichen Betriebszuständen definiert;
Bestimmen (608), ob einer des einen oder der mehreren Zustandsmetrik-Schwellenwerte überschritten wurde, basierend auf der bestimmten Zustandsmetrik, wobei der Zustandsmetrik-Schwellenwert für jeden Übergang zwischen jedem der möglichen Betriebszustände definiert ist; und
Übergehen (610) von dem aktuellen Betriebszustand in den Betriebszustand, der mit dem überschrittenen Zustandsmetrik-Schwellenwert assoziiert ist;
wobei die Zustandsmetrik-Schwellenwerte, die mit den Betriebszuständen assoziiert sind, überlappende Bereiche zwischen gemeinsamen Betriebszuständen vorsehen, um eine Hysteresis für Betriebszustandsübergänge vorzusehen.

8. Vorrichtung gemäß Anspruch 7, wobei die Kanalmetrik auf einem oder mehreren Kanalqualitätsindikatoren basiert, die für den empfangenen Funkfrequenzkanal bestimmt werden.

9. Vorrichtung gemäß Anspruch 8, wobei die Kanalmetrik eine Funktion eines oder mehrerer Kanalqualitätsindikatoren ist, die ausgewählt sind aus einem Signal-zu-Rauschen-Verhältnis des empfangenen Kanals, einer Bitfehlerrate des empfangenen Kanals, empfangenen Signalstärke-Messungen und Carrier-zu-Interferenz-plus-Rauschen-Verhältnissen (C/1+N - carrier-to-interference-plus-noise), wobei der oder jeder Kanalqualitätsindikator eine entsprechende Gewichtung bei einem Bestimmen der Kanalmetrik hat.

10. Vorrichtung gemäß einem der Ansprüche 7 bis 9, wobei die Zustandsmetrik eine Funktion eines Frequenzfehlers zwischen der Frequenz des empfangenen Funkfrequenzkanals und einer Ausgabefrequenz des VCOs aufweist.

11. Vorrichtung gemäß Anspruch 10, wobei die Zustandsmetrik weiter eine Funktion aus zumindest einem ist:
eine gewichtete Funktion der aktuellen Kanalmetrik; und
eine oder mehrere frühere Betriebszustandsmetriken, gewichtet mit einem Zeitparameter, wobei der Zeitparameter die Gewichtung der früheren Betriebszustandsmetrik verringert.

## Revendications

1. Procédé de poursuite en commande de fréquence non linéaire d'une boucle de commande d'un oscillateur (246) commandé en tension - ci-après abrégé par VCO - dans un récepteur d'un dispositif mobile sans fil (100), le procédé comprenant le fait :
de déterminer (602) une mesure de canal sur la base d'un ou de plusieurs indicateurs de qualité de canal associés à un canal radiofréquence reçu ;
de déterminer (604) une mesure d'état associée à l'état de fonctionnement actuel de la boucle de commande ;
de déterminer (606) une ou plusieurs valeurs seuil de mesure d'état associées à la mesure de canal déterminée, la ou les plusieurs valeurs seuil de mesure d'état sélectionnées parmi une pluralité de valeurs seuil de mesure d'état étant chacune associée à une transition vers un état de fonctionnement éventuel de la boucle de commande, à partir de l'état de fonctionnement actuel, en réalisant une consultation dans une table comprenant une ou plusieurs sous-tables, chaque sous-table étant associée à une valeur de mesure de canal ou à une plage de valeurs de mesure de canal, la table définissant une pluralité de seuils de mesure d'état pour chaque transition vers lesdits états de fonctionnement éventuels et à partir de ceux-ci ;
de déterminer (608) si une de la ou des plusieurs valeurs seuil de mesure d'état a été dépassée sur la base de la mesure d'état déterminée, où la valeur seuil de mesure d'état est définie pour chaque transition entre chacun desdits états de fonctionnement éventuels ;
d'effectuer une transition (610) de l'état de fonctionnement actuel à l'état de fonctionnement associé à la valeur seuil de mesure d'état dépassée ; et
de fournir (612) au moins un coefficient à un filtre à boucle adaptatif de la boucle de commande, l'au moins un coefficient étant associé à l'état de fonctionnement transitoire ;
où les valeurs seuil de mesure d'état associées aux états de fonctionnement fournissent des régions de chevauchement entre des états de fonctionnement communs pour fournir une hystérésis pour des transitions entre états de fonctionnement.

2. Procédé de la revendication 1, où la mesure de canal est basée sur un ou plusieurs indicateurs de qualité de canal déterminés pour le canal radiofréquence reçu.

3. Procédé de la revendication 2 dans lequel la mesure de canal est une fonction d'un ou de plusieurs indicateurs de qualité de canal sélectionnés parmi un rapport signal sur bruit du canal reçu, un taux d'erreurs sur les bits du canal reçu, des mesures d'intensité de signal reçu, et des rapports signal sur interférence plus bruit (C/L+N) où l'indicateur, ou chaque indicateur de qualité de canal, présente une pondération correspondante lors de la détermination de la mesure de canal.

4. Procédé de l'une quelconque des revendications 1 à 3 dans lequel la mesure d'état comprend une fonction d'une erreur de fréquence entre la fréquence du canal radiofréquence reçu et une fréquence de sortie de l'oscillateur VCO.

5. Procédé de la revendication 4, dans lequel la mesure d'état est en outre une fonction d'au moins l'une parmi :
une fonction pondérée de la mesure de canal actuelle ; et
une ou plusieurs mesures d'états de fonctionnement précédentes pondérées par un paramètre temporel, où le paramètre temporel diminue la pondération de la mesure d'état de fonctionnement précédente.

6. Procédé de l'une quelconque des revendications 1 à 5, dans lequel en déterminant une ou plusieurs valeurs seuil de mesure d'état est associée à un état d'initialisation, des coefficients d'initialisation par défaut définis pour le filtre à boucle adaptatif et dans lequel un seul seuil est défini pour la mesure de canal et dans lequel l'état d'initialisation se produit au démarrage du dispositif mobile sans fil.

7. Appareil (202) permettant de fournir une poursuite de fréquence non linéaire par hystérésis d'une boucle de commande dans un générateur de fréquences (113) d'un dispositif mobile sans fil (100) ayant un oscillateur (246) commandé en tension - ci-après abrégé par VCO - et un filtre à boucle adaptatif, l'appareil comprenant :
une mémoire (160, 162) ;
un processeur (120, 111) pour fournir des coefficients audit filtre à boucle adaptatif (244) parmi une pluralité de coefficients, chacun de la pluralité de coefficients étant associé à un état de fonctionnement du générateur de fréquences (113) dans lequel l'état de fonctionnement est déterminé :
en déterminant (602) une mesure de canal sur la base d'un ou de plusieurs indicateurs de qualité de canal associés à un canal radiofréquence reçu ;
en déterminant (604) une mesure d'état associée à la boucle de commande sur la base de l'état de fonctionnement de la boucle de commande ;
en déterminant (606) une ou plusieurs valeurs seuil de mesure d'état associées à la mesure de canal déterminée dans une table stockée dans la mémoire, à partir de la ou des plusieurs valeurs seuil de mesure d'état sélectionnées parmi une pluralité de valeurs seuil de mesure d'état étant chacune associée à une transition vers un état de fonctionnement éventuel de la boucle de commande à partir de l'état de fonctionnement actuel, en réalisant une consultation dans une table comprenant une ou plusieurs sous-tables chacune étant associée à une valeur de mesure de canal ou à une plage de valeurs de mesure de canal, la table définissant une pluralité de seuils de mesure d'état pour chaque transition vers lesdits états de fonctionnement éventuels et à partir de ceux-ci ;
en déterminant (608) si une parmi la ou les plusieurs valeurs seuil de mesure d'état a été dépassée sur la base de la mesure d'état déterminée, où la valeur seuil de mesure d'état est définie pour chaque transition entre chacun desdits états de fonctionnement éventuels ; et
en effectuant une transition (610) de l'état de fonctionnement actuel vers l'état de fonctionnement associé à la valeur seuil de mesure d'état dépassée ;
où les valeurs seuil de mesure d'état associées aux états de fonctionnement fournissent des régions de chevauchement entre des états de fonctionnement communs pour fournir une hystérésis pour des transitions entre états de fonctionnement.

8. Appareil de la revendication 7 dans lequel la mesure de canal est basée sur un ou plusieurs indicateurs de qualité de canal déterminés pour le canal radiofréquence reçu.

9. Appareil de la revendication 8, dans lequel la mesure de canal est une fonction d'un ou de plusieurs indicateurs de qualité de canal sélectionnés parmi un rapport signal sur bruit du canal reçu, un taux d'erreurs sur les bits du canal reçu, des mesures d'intensité de signal reçu, et des rapports signal sur interférence plus bruit (C/L+N) où le, ou chaque, indicateur de qualité de canal présente une pondération correspondante dans la détermination de la mesure de canal.

10. Appareil de l'une quelconque des revendications 7 à 9 dans lequel la mesure d'état comprend une fonction d'une erreur de fréquence entre la fréquence du canal radiofréquence reçu et une fréquence de sortie de l'oscillateur VCO.

11. Appareil de la revendication 10, dans lequel la mesure d'état est en outre une fonction d'au moins l'une de :
une fonction pondérée de la mesure de canal actuelle ; et
une ou plusieurs mesures d'états de fonctionnement précédentes pondérées par un paramètre temporel,
où le paramètre temporel diminue la pondération de la mesure d'état de fonctionnement précédente.
